## Europäisches Patentamt

## European Patent Office

## Office européen des brevets

(19)

(11) Publication number: **0 020 456**
**B1**

(12) **EUROPEAN PATENT SPECIFICATION**

(45) Date of publication of patent specification: **03.12.86**

(51) Int. Cl.⁴: **C 23 C 14/00, B 05 D 5/06, B 32 B 9/04**

(21) Application number: **79901261.2**

(22) Date of filing: **13.09.79**

(86) International application number:
**PCT/US79/00719**

(87) International publication number:
**WO 80/00713 17.04.80 Gazette 80/08**

(54) **TRANSPARENT HEAT MIRRORS FORMED ON POLYMERIC SUBSTRATES.**

(30) Priority: **27.09.78 US 946264**
**23.07.79 US 59794**

(43) Date of publication of application:
**07.01.81 Bulletin 81/01**

(45) Publication of the grant of the patent:
**03.12.86 Bulletin 86/49**

(84) Designated Contracting States:
**DE FR GB**

(56) References cited:
**JP-B-51 035 431**
**US-A-3 356 529**
**US-A-3 907 660**
**US-A-4 065 600**

**Applied Physics, Vol. 16, pp 239-246, Issued July 1978, Hoffman et al, HF-Sputtered Indium Oxide Films Doped With Tin, Fig. 1**

(73) Proprietor: **MASSACHUSETTS INSTITUTE OF TECHNOLOGY**
**77 Massachusetts Avenue**
**Cambridge, MA 02139 (US)**

(72) Inventor: **FAN, John C.C.**
**239 South Street**
**Chestnut Hill, MA 02167 (US)**

(74) Representative: **Holdcroft, James Gerald, Dr. et al**
**Graham Watt & Co. Riverhead**
**Sevenoaks Kent TN13 2BN (GB)**

(56) References cited:
**Journal Of The Elctrochemical Society, Vol. 126, No. 4, pp 691-694, Issued April 1979, Itoyama, Properties Of Sn-Doped Oxide Coatings Deposited On Polyester Film By High Rate Reactive Sputtering**

**THIN SOLID FILM, vol. 58, no. 2, April 1979, pages 379-384 Loughborough, G.B. R.P. HOWSON et al.: "Reactive ion plating of metal oxides onto insulating substrates"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**0 020 456**

(56) References cited:

**APPLIED PHYSICAL LETTERS, vol. 33, no. 7, October 1978, pages 643-645 (ITO) G. CHEEK et al.: "Fabrication and characterization of indium thin oxide (ITO)/polycrystalline silicon solar cells"**

**JOURNAL OF THE ELCTROCHEMICAL SOCIETY, vol. 122, no. 12, December 1975, J.C.C. FAN et al.: "Properties of Sn-doped In2O3 films prepared by RF sputtering"**

## Description

This invention is in the field of transparent heat mirrors for transmitting visible radiation and reflecting infrared radiation, and more particularly relates to transparent heat mirrors on polymeric substrates, such as flexible polymeric films.

Transparent heat mirrors are one class of spectrally selective coatings. They have optical properties which enable them to have high transmission of visible radiation and high reflectivity of infrared radiation. Such transparent heat mirrors have important applications as transparent thermal radiation shields with potential applications in solar energy collection, window insulation, etc.

One class of materials proposed for the formation of transparent heat mirrors is tin-doped indium oxide films. See, for example, Fan, J. C. C. and Bachner, F. J., *Applied Optics, Vol. 15*, No. 4, April 1976, pp 1012—1017; Fan. J C. C., Bachner, F. J. and Foley, G. H., *Applied Physics Letters, Vol. 31*, No. 11, December 1977, pp 773—775; and Fan, J. C. C. and Bachner, F. J., *J.* Electrochem. Soc.: Solid-State Science and Technology, *Vol. 122*, No. 12, December 1975, pp 1719—1725.

As evidenced by the aforementioned publications, tin-doped indium oxide films having sufficient optical properties to make them useful as transparent heat mirrors have been formed. Typically, however, such films have required either substrate temperatures during the deposition process exceeding the temperature resistance properties of most polymer films or a post-treatment, such as annealing, also requiring temperatures beyond those which most polymer films can tolerate. Almost all previous work in regard to these films involved radio frequency diode sputtering, which has too much intrinsic heating and electron bombardment for most available polymeric substrates. These obstacles to obtaining tin-doped indium oxide film of good wave-length selective properties on polymeric film have been recognized in the art. See, for example, Fan, J. C. C., Solid-State Chemistry of Energy Conversion and Storage, Advances in Chemistry Series 163, American Chemical Society, 1977, pp 149—164; and Sobajima et al., Proc. 6th International Vacuum Congress, 1974, Japan J. Appl. Phys. Suppl. 2, Pt. 1, 1974, pp 475—478. Further in Applied Physics, Vol. 16, pages 239—246 (1978) indium oxide films doped with tin have been hf-sputtered from an 80 at.-% $In_2O_3$/20 at.-% $SnO_2$ target on glass substrates. The sputter atmosphere contained mainly argon ($10^{-2}$ Torr) with addition of oxygen ($0 \leqq P_{o2} \leqq 2.10^{-2}$ Torr).

The invention provides a method of producing transparent heat-mirrors by deposition of a film of doped indium oxide or doped tin oxide onto a substrate, characterised in that the deposition comprises low temperature deposition onto a polymeric substrate by sputtering, thermal evaporation, vacuum deposition or electron bombardment, and a partial pressure of oxygen is employed during deposition within a range which produces directly films of said material with a high transparency to the visible solar spectrum and a high reflectivity to the infrared spectrum.

In embodiments of the invention the material comprises tin-doped indium oxide or antimony doped tin oxide; and the substrate is a flexible polymeric film of e.g. polyethylene terephthalate.

The said partial pressure of oxygen is for example between $1.33 \times 10^{-3}$ Pa ($1 \times 10^{-5}$ Torr) and $8 \times 10^{-3}$ Pa ($6 \times 10^{-5}$ Torr), and may be e.g. below about $6.67 \times 10^{-3}$ Pa ($5 \times 10^{-5}$ Torr).

The doped indium oxide or doped tin oxide films can be successfully formed on polymeric films by employing the low temperature deposition process and by carefully controlling the partial pressure of oxygen during deposition.

In one embodiment, for example, an ion beam sputtering process is employed to deposit a tin-doped indium oxide film because the deposition does not heat the substrate to temperatures beyond that tolerable by many polymeric films. A target source containing a mixture of indium oxide and tin or tin oxide is bombarded with argon ions to cause ejection of atoms from the target source. During this deposition process, sufficient oxygen is admitted to the sputtering chamber to maintain the partial pressure within the chamber at a level between $2.67 \times 10^{-3}$ Pa ($2 \times 10^{-5}$ Torr) and $6.67 \times 10^{-3}$ Pa ($5 \times 10^{-5}$ Torr).

This invention allows high quality transparent, heat-reflecting films to be deposited at low temperatures without any requirement for a post-deposition treatment to improve the quality of the films. Thus, transparent heat mirrors can be formed from tin-doped indium oxide and antimony-doped tin oxide films on polymeric substrates. This dramatically increases the useful applications for transparent heat mirrors formed from these materials.

In the drawings:

Fig. 1 is a schematic diagram of an ion-beam sputtering apparatus suitable for forming transparent heat mirrors according to this invention;

Fig. 2 is a plot of the partial pressure of oxygen versus resistivity of the films formed in an ion-beam sputtering process employing argon ions;

Fig. 3 is a plot of the partial pressure of oxygen versus the effective reflectivity at 10 μm for films produced in the same ion-beam sputtering process and,

Fig. 4 is a plot of the partial pressure of oxygen versus the integrated transmission of films formed in the same ion-beam sputtering process.

A preferred embodiment of this invention is illustrated in specific detail by reference to the Figures.

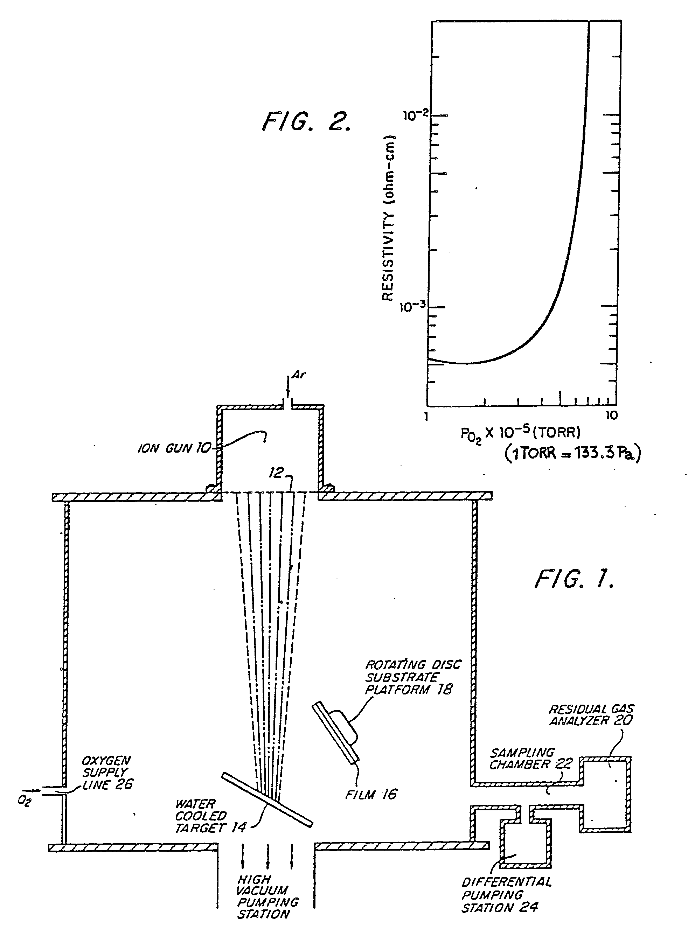

Fig. 1 is a schematic illustration of the ion-beam sputtering apparatus. An ion-beam gun 10, such as that sold by Commonwealth Scientific Corp., Alexandria, Virginia, or Ion Tech, Inc., Ft. Collins, Colorado, is provided to ionize a gas, such as argon, which is fed into the gun chamber. The argon ions are accelerated by an extractor voltage and directed to the target by grid 12. This stream of argon ions bombards a water-cooled target source 14 of material to be deposited, such as a mixture of indium oxide and tin oxide. Target source 14 is cooled to prevent overheating, and this can be achieved by providing a water jacket at its back side. A polymeric film 16 to be coated is mounted on a rotating disc substrate platform 18.

The partial pressure of oxygen can be monitored in the deposition chamber by a residual gas analyzer 20, such as the one marketed by UTI, Sunnyvale, California, under Model No. 100 Nsy. Residual gas analyzer 20 is attached to a sampling chamber 22 with its own pumping station 24 which is connected to the main sputtering chamber through a capillary leak. Oxygen is introduced through an oxygen supply line 26 to maintain the partial pressure of oxygen in the chamber at the desired level.

Fig. 2 shows the relationship of resistivity for films deposited on Mylar® polyethylene terephthalate films in an apparatus of Figure 1. As can be seen, the resistivity is approximately constant for partial pressures of oxygen of up to about $6.67 \times 10^{-3}$ Pa ($5 \times 10^{-5}$ Torr) but then rapidly rises.

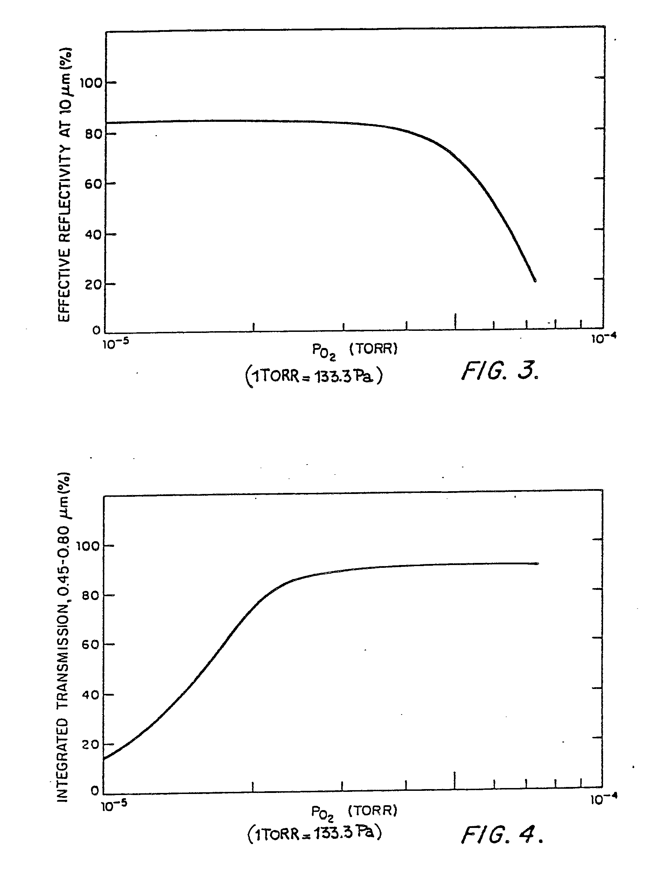

This increase in resistivity usually means that the reflectivity in the infrared (by free electron effects) will go down. Figure 3 confirms this effect. Therein, it can be seen that the reflectivity at 10 micrometers is about 84% for films (about 0.5 μm thick) prepared at partial pressures of oxygen of up to about $6.67 \times 10^{-3}$ Pa ($5 \times 10^{-5}$ Torr), but decreases for higher partial pressures of oxygen. The infrared measurements were made with a Gier Dunkle reflectometer which uses integrating spheres to determine the integrated reflectivity at near-normal incidence of radiation from a room-temperature blackbody, where emission peaks at 10 μm.

Fig. 4 illustrates the integrated optical transmission of 0.5 μm thick tin-doped indium oxide films over the range 0.45—0.80 μm wavelength, as a function of partial pressure of oxygen. At low partial pressures, the transparency was quite low and the films appeared dark. With increasing partial pressures, transparency at first increased rapidly exceeding 80% at $4 \times 10^{-3}$ Pa ($3 \times 10^{-5}$ Torr), and then became constant at over 90% for higher partial pressures. Transmissions were plotted with the effects of substrates excluded. Although these measurements were made for 0.5 μm thick films, the infrared reflectivity of these films at 10 μm is quite insensitive to film thickness as long as the films are over 0.3 μm thick. Of course, as the films get thinner, the visible transmission increases.

From these, it can be seen that tin-doped indium oxide films having good transparent heat-reflecting properties can be prepared in an ion-beam sputtering process if the partial pressure is maintained between $2.67 \times 10^{-3}$ Pa ($2 \times 10^{-5}$ Torr)

and $6.67 \times 10^{-3}$ Pa ($5 \times 10^{-5}$ Torr). The experiments described were done with a deposition rate of about $2 \times 10^{-2}$ μm (200 Å)/min. Initial experiments at other deposition rates varying from $1 \times 10^{-2}$ μm (100 Å)/min. to $4 \times 10^{-2}$ μm (400 Å)/min. indicate that the effective range of partial pressure of oxygen shifts slightly with the rate of deposition. For example, at a deposition rate of $1 \times 10^{-2}$ μm (100 Å)/min., the effective range of oxygen partial pressure was from $1.33 \times 10^{-3}$ to $5.33 \times 10^{-3}$ Pa ($1.0 \times 10^{-5}$ to $4 \times 10^{-5}$ Torr); at a deposition rate of $4 \times 10^{-2}$ μm (400 Å)/min., the effective range was $4 \times 10^{-3}$ to $8 \times 10^{-3}$ Pa ($3 \times 10^{-5}$ to $6 \times 10^{-5}$ Torr).

In general, the oxygen window for good quality films is very narrow and slightly sensitive to deposition conditions. At deposition rates of about $2 \times 10^{-2}$ μm (200 Å)/min., this window is from $2.67 \times 10^{-3}$ to $6.67 \times 10^{-3}$ Pa ($2 \times 10^{-5}$ to $5 \times 10^{-5}$ Torr). At lower deposition rates, the oxygen window is shifted slightly to lower partial pressures of oxygen whereas at higher rates, it is shifted slightly higher.

Although an ion-beam sputtering process has been specifically described, any low temperature deposition process is suitable if it does not elevate the substrate temperatures above those tolerable by the polymeric substrates.

Good quality transparent heat-reflecting films having comparable properties to those prepared by ion-beam sputtering have been deposited by thermal evaporation of tin-doped indium oxide from tantalum and platinum boats containing mixtures of indium oxide and tin oxide. In this case, partial oxygen pressure was maintained at about $5.33$—$6.67 \times 10^{-3}$ Pa ($4$—$5 \times 10^{-5}$ Torr) at a deposition rate of $2 \times 10^{-2}$ μm (200 Å)/min. The oxygen was fed into a vacuum system through nozzle jets directed at the space directly above the evaporation boat for optimal control of film quality. No post deposition annealing was required.

Other low temperature processes include magnetron sputtering, triode sputtering, and certain vacuum deposition processes that do not cause excessive heating of the substrate or electron bombardment.

The choice of specific polymer substrates will, of course, depend upon the exact application. Some examples of films include Mylar polyethylene terephthalate, Lexan polycarbonate, Kapton polyimide and FEP Teflon.

Although the experimental work described above was done with tin-doped indium oxide, antimony-doped tin oxide films can also be deposited at low temperatures on polymeric substrates by the techniques described. In addition, however, any doping species which provides free charge carriers can be employed. For example, in the $In_2O_3$ case, the dopants can be Sn, Ge, Si or Sb. Doping can also be achieved by oxygen deficiencies. In the $SnO_2$ case, examples of suitable dopants include Sb or Bi.

**Claims**

1. A method of producing transparent heat

mirrors by deposition of a film of doped indium oxide or doped tin oxide onto a substrate, characterised in that the deposition comprises low temperature deposition onto a polymeric substrate by sputtering, thermal evaporation, vacuum deposition or electron bombardment, and a partial pressure of oxygen is employed during deposition within a range which produces directly films of said material with a high transparency to the visible solar spectrum and a high reflectivity to the infrared spectrum.

2. A method according to claim 1, wherein said partial pressure of oxygen is between $1.33\times10^{-3}$ Pa ($1\times10^{-5}$ Torr) and $8\times10^{-3}$ Pa ($6\times10^{-5}$ Torr).

3. A method according to claim 1 or claim 2, wherein said material comprises tin-doped indium oxide or antimony-doped tin oxide.

4. A method according to claim 3, wherein said partial pressure of oxygen is below about $6.67\times10^{-3}$ Pa ($5\times10^{-5}$ Torr).

5. A method according to claim 1 or claim 2 comprising: (a) providing a target source of indium oxide and tin oxide or tin in an ion-beam sputtering chamber; (b) mounting the polymeric substrate at a location within said ion-beam sputtering chamber where deposition of tin-doped indium oxide occurs; and (c) bombarding said target source with ions sufficient to cause ejection of the target source material.

6. A method according to claim 5, wherein the bombarding ions comprise argon ions.

7. A method according to any one of the preceding claims, wherein said polymeric substrate comprises a polymeric film.

8. A method according to any one of the preceding claims, wherein the polymeric substrate comprises a polyethylene terephthalate film.

## Patentansprüche

1. Verfahren zum Herstellen transparenter Wärmespiegel durch Ablagerung eines Films aus versetztem Indiumoxid oder versetztem Zinnoxid auf ein Substrat, dadurch gekennzeichnet, daß als Ablagerung eine Niedrigtemperatur - Ablagerung auf ein Polymer-Substrat durch Zerstäubung, thermische Verdampfung, Vakuumaufdampfung oder Elektronenbeschuß verwendet und während der Ablagerung ein Sauerstoff - Partialdruck in einem Bereich verwendet wird, der unmittelbar Filme des genannten Materials mit einer hohen Transparenz gegenüber dem sichtbaren Sonnenspektrum und einem hohen Reflexionsvermögen gegenüber dem Infrarotspektrum erzeugt.

2. Verfahren nach Anspruch 1, dadurch gekennzeichnet, daß der Sauerstoff - Partialdruck zwischen $1,33\times10^{-3}$ Pa ($1\times10^{-5}$ Torr) und $8\times10^{-3}$ Pa ($6\times10^{-5}$ Torr) beträgt.

3. Verfahren nach Anspruch 1 oder 2, dadurch gekennzeichnet, daß das Material aus zinnversetztem Indiumoxid oder antimonversetztem Zinnoxid besteht.

4. Verfahren nach Anspruch 3, dadurch gekennzeichnet, daß der Sauerstoff-Partialdruck unter etwa ($6,67\times10^{-3}$ Pa ($5\times10^{-5}$ Torr) liegt.

5. Verfahren nach Anspruch 1 oder 2, dadurch gekennzeichnet, daß (a) eine Targetquelle von Indiumoxid und Zinnoxid oder Zinn in einer Ionenstrahlzerstäuberkammer vorgesehen, (b) das Polymer-Substrat an einer Stelle innerhalb der Ionenstrahlzerstäuberkammer, an der eine Ablagerung von zinnversetztem Indiumoxid eintritt, angebracht und (c) die Tragetquelle einem Ionenbeschuß in dem Maße ausgesetzt wird, daß ein Auswerfen des Targetquellenmaterials hervorgerufen wird.

6. Verfahren nach Anspruch 5, dadurch gekennzeichnet, daß als Beschußionen Argonionen verwendet werden.

7. Verfahren nach einem der vorhergehenden Ansprüche, dadurch gekennzeichnet, daß als Polymer-Substrat ein Polymerfilm verwendet wird.

8. Verfahren nach einem der vorhergehenden Ansprüche, dadurch gekennzeichnet, daß als Polymer-Substrat ein Polyäthylenterephthalatfilm verwendet wird.

## Revendications

1. Procédé de fabrication de miroirs thermiques transparents en déposant une couche d'oxyde d'indium doppé ou d'oxyde d'étain doppé sur un substrat, caractérisé en ce que le dépôt comprend le dépôt à basse température sur un substrat polymère par pulvérisation cathodique, évaporation thermique, dépôt sous vide ou bombardement par électrons, et qu'une pression partielle de l'oxygène est utilisée pendant le dépôt dans une bande qui produit directement des couches de ladite matière avec une transparence élevée au spectre solaire visible et un pouvoir de réflexion élevé au spectre infrarouge.

2. Procédé selon la revendication 1, dans lequel ladite pression partielle de l'oxygène est comprise entre $1,33\times10^{-3}$ Pa ($1\times10^{-5}$ Torr) et $8\times10^{-3}$ Pa ($6\times10^{-5}$ Torr).

3. Procédé selon la revendication 1 ou 2, dans lequel la matière est de l'oxyde d'indium doppé à l'étain ou de l'oxyde d'étain doppé à l'antimoine.

4. Procédé selon la revendication 3, dans lequel ladite pression partielle de l'oxygène est inférieure à environ ($6,67\times10^{-3}$ Pa ($5\times10^{-5}$ Torr).

5. Procédé selon la revendication 1 ou 2, comprenant: (a) la mise à disposition d'une cible source d'oxyde d'indium et d'oxyde d'étain ou d'étain dans une chambre de pulvérisation cathodique à faisceau d'ions; (b) de monter le substrat polymère en un endroit dans ladite chambre de pulvérisation cathodique à faisceau d'ions où le dépôt de l'oxyde d'indium doppé à l'étain se fait; et (c) de bombarder ladite cible d'ions suffisants pour causer l'éjection de matière de source de la cible.

6. Procédé selon la revendication 5, dans lequel le bombardement aux ions se fait aux ions d'argon.

7. Procédé selon l'une quelconque des revendications précédentes, dans lequel ledit substrat polymère est un film polymère.

8. Procédé selon l'une quelconque des revendications précédentes, dans lequel le substrat polymère est un film de polytéréphtalate d'éthylène.

FIG. 2.

RESISTIVITY (ohm-cm)

$10^{-2}$

$10^{-3}$

$P_{O_2} \times 10^{-5}$ (TORR)

(1 TORR = 133.3 Pa)

Ar

ION GUN 10

12

ROTATING DISC
SUBSTRATE
PLATFORM 18

FIG. 1.

RESIDUAL GAS
ANALYZER 20

OXYGEN
SUPPLY
LINE 26

SAMPLING
CHAMBER 22

$O_2$

WATER
COOLED
TARGET 14

FILM 16

HIGH
VACUUM
PUMPING
STATION

DIFFERENTIAL
PUMPING
STATION 24

1

FIG. 3.

FIG. 4.